(19) Europäisches Patentamt
European Patent Office
Office européen des brevets

(11) **EP 3 226 011 A1**

(12) **EUROPÄISCHE PATENTANMELDUNG**

(43) Veröffentlichungstag:
**04.10.2017 Patentblatt 2017/40**

(51) Int Cl.:
**G01R 1/20** *(2006.01)* **G01R 15/14** *(2006.01)*
**G01R 19/00** *(2006.01)*

(21) Anmeldenummer: **16162878.9**

(22) Anmeldetag: **30.03.2016**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Siemens Aktiengesellschaft**
**80333 München (DE)**

(72) Erfinder:
• **Lutze, Marcel**
 **90459 Nürnberg (DE)**
• **Pfeifer, Markus**
 **90455 Nürnberg (DE)**

(54) **VORRICHTUNG UND VERFAHREN ZUR MESSUNG EINER STROMSTÄRKE IN EINEM ELEKTRISCHEN LEITER**

(57) Die Erfindung betrifft eine Vorrichtung und ein Verfahren zur Messung einer Stromstärke ($I_{IN}$) in einem elektrischen Leiter (L), wobei eine Messeinrichtung (S) zur Messung der Stromstärke vorgesehen wird. Dabei wird der elektrische Leiter (L) in eine Anzahl Teil-Leiter aufgeteilt, wobei die Teil-Leiter an ihren jeweiligen Enden elektrisch miteinander verbunden und in einem Bereich zwischen den jeweiligen Enden elektrisch voneinander isoliert werden, wobei die Messeinrichtung (S) zur Messung einer Teil-Stromstärke ($I_2$) in einem ersten der Teil-Leiter als Nebenstrompfad verwendet wird und die verbleibenden Teil-Leiter einen Hauptstrompfad bilden, und wobei eine Skaliereinrichtung die Ermittlung der Stromstärke ($I_{IN}$) aus einem Messwert der Teil-Stromstärke ($I_2$) und anhand eines Teilungsverhältnis zwischen Nebenstrompfad und dem Hauptstrompfad oder dem gesamten Leiter (L) vornimmt. Durch die Beschränkung der messtechnischen Erfassung auf einen Teil-Strom kann eine kleinere, leichtere Messeinrichtung (Stromsensor) verwendet werden.

Fig. 1

**EP 3 226 011 A1**

**Beschreibung**

Die Erfindung betrifft eine Vorrichtung zur Messung einer Stromstärke in einem elektrischen Leiter gemäß dem Oberbegriff des Patentanspruchs 1, und ein Verfahren zur Messung einer Stromstärke in einem elektrischen Leiter gemäß dem Oberbegriff des Patentanspruchs 12.

Bei der Messung von Gleich- und/oder Wechselströmen in Umrichtern (Leistungselektronik) oder bei Antrieben werden in der Regel Stromsensoren (Messvorrichtungen zur Messung der Stromstärke) mit Ringkernen oder Shunts verwendet.

Bei zunehmender Höhe des zu messenden Stroms ergibt sich dabei zum Einen das Problem, dass bei Stromsensoren mit Ringkern durch die größer werdenden Magnetfelder das Kernvolumen zunehmen muss, um Sättigungseffekte zu verhindern. Dadurch wächst das Bauvolumen der Stromsensoren an. Bei Kompensationsstromwandlern mit einer Sekundärwicklung auf dem Ringkern nimmt zudem häufig aufgrund nötig werdender höherer Windungszahl und größeren Drahtquerschnitts auch noch das Volumen der Sekundärwicklung zu, wodurch das Bauvolumen weiter wächst. Insgesamt führt bei Stromsensoren mit Ringkern also eine Erhöhung des zu messenden Stroms zu einer Zunahme des Bauvolumens und der Masse.

Bei der Strommessung mit Shunts (Messwiderstand) muss zur Erreichung einer bestimmten Messgenauigkeit beim Maximalstrom eine entsprechende Mindestspannung abfallen (bestimmt durch den Rauschpegel der im System verwendeten Komponenten). Eine Erhöhung des zu messenden Stroms führt deshalb aufgrund des minimal zur Erreichung einer bestimmten Messgenauigkeit nötigen Spannungsabfalls am Shunt automatisch zu einer größeren Verlustleistung im Shunt und deshalb in der Regel zu einer größeren Bauform und Masse des Shunts, um die höhere Verlustleistung abführen zu können.

Allgemein sinkt mit steigender Baugröße bzw. steigendem Messbereich oft die nutzbare Bandbreite der Strom-Messeinrichtungen, so dass insbesondere in der Energieversorgung und Leistungselektronik transiente Vorgänge nicht präzise erfasst werden können.

Bisher wird die Zunahme des Bauvolumens und der Masse von Shunts bzw. Stromsensoren bei der Messung höherer Ströme akzeptiert und äußert sich in einem höheren Bauvolumen bzw. Masse des Geräts, in dem die Strommessung integriert ist.

Es ist eine Aufgabe der vorliegenden Erfindung, eine Vorrichtung zur Messung der Stromstärke in einem elektrischen Leiter vorzuschlagen, die präzise ist und eine kompakte Bauform aufweist. Ferner ist es Aufgabe der Erfindung, ein verbessertes Verfahren zur Messung der Stromstärke in einem elektrischen Leiter bereitzustellen, welches insbesondere präzise und mittels kompakter Anordnungen durchgeführt werden kann.

Es ist eine Kernidee der erfindungsgemäßen Lösung dieser Aufgabe, einen stromführenden Leiter, insbesondere eine Stromschiene oder einen Streifenleiter einer Leiterplatte, in Teil-Leiter aufzuteilen, und nur den Strom in einem der Teil-Leiter, vorzugsweise dem mit dem geringeren Querschnitt, zu messen, und aus diesem Messergebnis den Gesamtstrom zu berechnen. Da anstelle des Gesamtstroms nur ein Teilstrom gemessen werden muss, können kleinere, leichtere Stromsensoren verwendet werden.

Diese Aufgabe der Erfindung wird insbesondere mit Vorrichtungen mit den in den Ansprüchen 1 und 9 angegebenen Merkmalen sowie mit Verfahren mit den in den Ansprüchen 12 und 13 angegebenen Merkmalen gelöst. Bevorzugte Weiterbildungen der Erfindung sind in den zugehörigen Unteransprüchen, der nachfolgenden Beschreibung und der Zeichnung angegeben.

Dabei wird eine Vorrichtung zur Messung einer Stromstärke in einem elektrischen Leiter vorgeschlagen, wobei eine Messeinrichtung zur Messung der Stromstärke vorgesehen ist. Dabei ist der elektrische Leiter in eine Anzahl Teil-Leiter aufgeteilt, wobei die Teil-Leiter an ihren jeweiligen Enden miteinander elektrisch verbunden und in einem Bereich zwischen den jeweiligen Enden elektrisch voneinander isoliert sind, wobei die Messeinrichtung zur Messung einer Teil-Stromstärke in einem ersten der Teil-Leiter als Nebenstrompfad angeordnet ist und die verbleibenden Teil-Leiter einen Hauptstrompfad bilden, und wobei eine Skaliereinrichtung zur Ermittlung der Stromstärke aus einem Messwert der Teil-Stromstärke und anhand eines Teilungsverhältnis zwischen Nebenstrompfad und dem Hauptstrompfad oder dem gesamten Leiter vorgesehen ist. Durch die Beschränkung der messtechnischen Erfassung auf einen Teil-Strom kann eine kleinere, leichtere Messeinrichtung (Stromsensor) verwendet werden.

Alternativ oder zusätzlich wird die Aufgabe der Erfindung mit einer Vorrichtung zur Messung einer Stromstärke eines Stromes in einem elektrischen Leiter mit einer Messeinrichtung zur Messung der Stromstärke gelöst, wobei der elektrische Leiter in eine Anzahl Teil-Leiter aufgeteilt ist, wobei die Messeinrichtung zur Messung einer Teil-Stromstärke in oder an zumindest einem ersten der Teil-Leiter als Nebenstrompfad angeordnet ist, wobei die Vorrichtung ausgebildet ist, zur Ermittlung der Stromstärke zumindest einen Messwert der Teil-Stromstärke heranzuziehen und wobei die Vorrichtung, insbesondere die Messeinrichtung oder die ggf. vorhandene Skaliereinrichtung, ausgebildet ist, eine Frequenz des Stromes zur Ermittlung der Stromstärke heranzuziehen. Auf diese Weise lässt sich die Stromstärke besonders genau auch bei hohen Frequenzen ermitteln.

In einer vorteilhaften Weiterbildung der Erfindung ist die Messeinrichtung ausgebildet, die Frequenz des Stromes, vorzugsweise am oder im Nebenstrompfad, zu erfassen.

Vorzugsweise ist die Messeinrichtung ausgebildet, die Frequenz mittels der Erfassung der Rate an Nulldurchgängen des Messwerts für die Teil-Stromstärke zu erfassen.

Außerdem wird zur Lösung der Aufgabe ein Verfahren zur Messung einer Stromstärke in einem elektrischen Leiter vorgeschlagen, wobei eine Messeinrichtung zur Messung der Stromstärke vorgesehen wird. Dabei ist vorgesehen, dass der elektrische Leiter in eine Anzahl Teil-Leiter aufgeteilt wird, wobei die Teil-Leiter an ihren jeweiligen Enden miteinander elektrisch verbunden und in einem Bereich zwischen den jeweiligen Enden elektrisch voneinander isoliert werden, wobei die Messeinrichtung zur Messung einer Teil-Stromstärke in einem ersten der Teil-Leiter als Nebenstrompfad verwendet wird und die verbleibenden Teil-Leiter einen Hauptstrompfad bilden, und wobei eine Skaliereinrichtung die Ermittlung der Stromstärke aus einem Messwert der Teil-Stromstärke und anhand eines Teilungsverhältnis zwischen Nebenstrompfad und dem Hauptstrompfad oder dem gesamten Leiter vornimmt. Mit diesem Verfahren können die bereits anhand der Vorrichtung diskutierten Vorteile realisiert werden.

Alternativ oder zusätzlich zum vorbeschriebenen erfindungsgemäßen Verfahren wird bei einem weiteren erfindungsgemäßen Verfahren zur Messung einer Stromstärke in einem elektrischen Leiter eine Messeinrichtung zur Messung der Stromstärke herangezogen, wobei ein elektrische Leiter herangezogen wird, der in eine Anzahl Teil-Leiter aufgeteilt ist, wobei die Messeinrichtung zur Messung einer Teil-Stromstärke in oder an einem ersten der Teil-Leiter als Nebenstrompfad verwendet wird und die verbleibenden Teil-Leiter einen Hauptstrompfad bilden, und wobei zur Ermittlung der Stromstärke vorzugsweise zumindest ein Messwert der Teil-Stromstärke herangezogen wird und wobei zudem eine Frequenz des Stroms herangezogen wird.

Auf diese Weise lässt sich mittels des erfindungsgemäßen Verfahrens die Stromstärke besonders genau auch bei hohen Frequenzen ermitteln.

In einer vorteilhaften Weiterbildung der Erfindung wird bei dem Verfahren die Frequenz des Stromes, vorzugsweise am oder im Nebenstrompfad, erfasst.

Vorzugsweise wird bei dem erfindungsgemäßen Verfahren die Frequenz mittels eines frequenzabhängigen Korrekturfaktors berücksichtigt, mittels welchem ein für den Gleichstromfall skalierter Messwert der Teil-Stromstärke zur Ermittlung des Gesamtstroms zusätzlich korrigiert wird.

Zweckmäßig ist ein solcher Korrekturfaktor vorab über eine Messung des Frequenzgangs der Vorrichtung bestimmt worden und liegt als Korrekturfaktor-Tabelle oder als Korrekturfaktor-Funktion vor und wird bei der Durchführung des erfindungsgemäßen Verfahrens herangezogen.

Alternativ oder zusätzlich liegt der frequenzabhängige Korrekturfaktor als Modellfunktion, insbesondere eines zuvor modellierten Modells eines Ersatzschaltbildes, vor und wird bei der Durchführung des erfindungsgemäßen Verfahrens herangezogen.

In einem weiteren, nicht eigens dargestellten Ausführungsbeispiel, welches im Übrigen dem Dargestellten entspricht, ist die jeweilige Frequenz des Stroms oder eine Menge mehrerer diskreter Frequenzen vorab bekannt, sodass anstelle einer messtechnischen Erfassung der Frequenz lediglich eine parameterartige Berücksichtigung dieser diskreten im Betrieb möglichen Frequenzen erforderlich ist.

Zweckmäßig wird somit lediglich ein Korrekturfaktor für diese Frequenz(en) vorgehalten und berücksichtigt.

Vorteilhafte Ausgestaltungen der Erfindung sind in den abhängigen Patentansprüchen angegeben. Die für die erfindungsgemäßen Vorrichtungen angegebenen vorteilhaften Ausgestaltungen gelten sinngemäß auch für die erfindungsgemäßen Verfahren, und umgekehrt. Die in den abhängigen Patentansprüchen diskutierten vorteilhaften Ausgestaltungen können sowohl einzeln, als auch in beliebiger Kombination miteinander realisiert werden.

Vorteilhaft ist der elektrische Leiter streifenförmig, wobei durch eine schlitzförmige Unterbrechung in Längsrichtung eine Teilung in Hauptstrompfad und Nebenstrompfad gegeben ist. Dadurch ist die Erfindung gut auf Stromschienen in der elektrischen Energieversorgung und auf Leiterbahnen von Leiterplatten anwendbar. Die Unterteilung des Leiters in Teil-Leiter lässt sich bei diesen Anwendungen auch gut nachträglich gestalten, beispielsweise durch Einfräsen von Unterbrechungen.

Die Erfindung ist auch vorteilhaft einsetzbar, wenn der elektrische Leiter mehradrig ist, wobei durch Herausführung oder Spleißung einer Anzahl Adern eine Teilung in Hauptstrompfad und Nebenstrompfad möglich ist.

Eine universell einsetzbare Lösung, insbesondere zur Nachrüstung bestehender Anlagen, ist gegeben, indem der elektrische Leiter aus einem Hauptleiter und einem zusätzlich vorgesehenen und parallel angeordnetem Messleiter besteht, wobei der Hauptleiter den Hauptstrompfad und der Messleiter den Nebenstrompfad bildet.

Vorteilhaft ist das durch die Skaliereinrichtung verwendete Teilungsverhältnis anhand des Verhältnisses der Impedanz des Nebenstrompfades zu der Impedanz des Hauptstrompfades bestimmt, so dass Messwerte der Impedanzen genutzt werden können, was insbesondere bei unregelmäßigen Geometrien zweckmäßig ist. Alternativ kann insbesondere bei streifenförmigen Leitern, bei denen ein linearer Zusammenhang zwischen der Breite eines Strompfades und dem längenbezogenen Widerstand bzw. Impedanz besteht, vorteilhaft das durch die Skaliereinrichtung verwendete Teilungsverhältnis anhand des Verhältnisses des gesamten Leiterquerschnitts des Leiters zu dem Leiterquerschnitt des Nebenstrompfades bestimmt werden.

Die Skaliereinrichtung kann vorteilhaft durch eine in Software ausgestaltete Umrechnung der Messwerte realisiert sein.

Ausführungsbeispiele der erfindungsgemäßen Lösung werden nachfolgend anhand der Zeichnungen erläutert.

Dabei zeigen:

Figur 1    eine erste Ausführungsform mit einer in Längsrichtung geschlitzten Leiterbahn oder Stromschiene,

Figur 2    eine zweite Ausführungsform mit einem Kabel zur Realisierung des Nebenstrompfades, und

Figur 3    ein elektrisches Ersatzschaltbild der Messvorrichtungen aus Figur 1 und Figur 2.

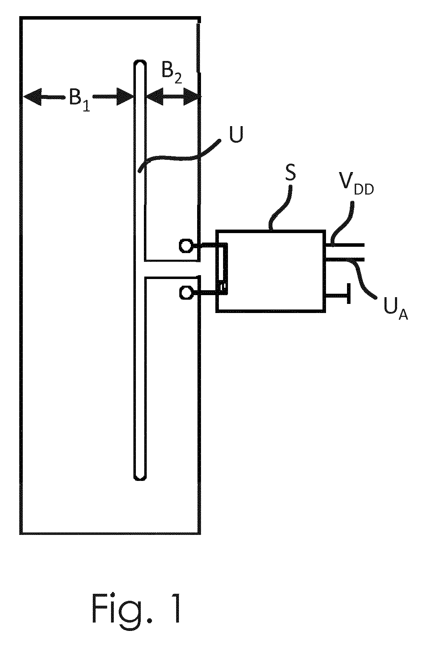

In der Figur 1 ist ein Leiter L dargestellt, beispielsweise eine Stromschiene zur elektrischen Versorgung eines elektrischen Verbrauchers. Der Leiter L ist mit einer schlitzförmigen Unterbrechung U versehen, die zum einen den Leiter L in einen Hauptstrompfad mit der Breite $B_1$ und einen Nebenstrompfad mit der Breite $B_2$ unterteilt. Zudem unterbricht die Unterbrechung U den Nebenstrompfad, so dass der Strom des Nebenstrompfades durch den Sensor S geleitet wird. Der Sensor S ist dabei eine Strommesseinrichtung gemäß dem Stand der Technik, beispielsweise ein induktiver Stromwandler, ein Kompensationsstromwandler oder ein Shunt. Der Sensor S verfügt ggf. über eine Spannungsversorgung $V_{DD}$ und hat einen Ausgang $U_A$ mit dem Meßsignal.

Bei der abgebildeten Vorrichtung wird der zu messende Strom im Leiter L gemäß dem Breitenverhältnis $B_1$ zu $B_2$ im Verhältnis 1:n geteilt, wobei nur der um den Faktor n geteilte Strom im Nebenstrompfad gemessen wird. Der Gesamtstrom errechnet sich aus dem Messergebnis als das (n+1)-fache des gemessenen Teilstroms; zur Berechnung kann eine einfache Skalierungseinrichtung (nicht dargestellt) verwendet werden. Dadurch kann ein Sensor S (Stromsensor) verwendet werden, der statt des Gesamtstroms nur den n-ten oder (n+1)-ten Teil des Gesamtstroms messen kann, d.h. die Anordnung erweitert den Messbereich eines Stromsensors um den Faktor n.

Zur Stromteilung wird parallel zum Hauptstrompfad einen Nebenstrompfad (Parallelpfad) mit höherem Widerstand bzw. größerer Impedanz realisiert, der über den Sensor S (Stromsensor) geschlossen ist. Dieser Strom im Parallelpfad wird also mit Hilfe des Sensors S gemessen. Das Teilungsverhältnis der Ströme von Haupt- und Parallelstrompfad ergibt sich aus dem Verhältnis des ohmschen Widerstands von Haupt- und Parallelstrompfad. Bei streifenförmigen Leitern mit über die Breite konstanter Dicke entspricht das Teilungsverhältnis dem Verhältnis der Breiten $B_1$ zu $B_2$.

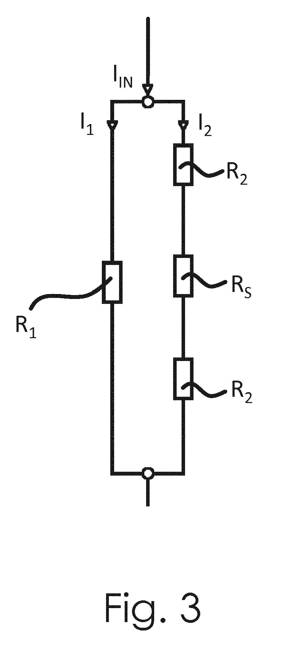

In der Figur 3 ist ein Ersatzschaltbild dazu angegeben.

Die Realisierung gemäß Figur 1 beruht auf einem Schlitz als Unterbrechung U in einer Stromschiene oder Leiterbahn. Die Widerstände der Teil-Leiter zu beiden Seiten des Schlitzes, also des Haupt- und des Nebenstrompfades, ergeben sich aus der Geometrie und der Leitfähigkeit des Materials zu $R_1$ und zweimal $R_2$ (ober- und unterhalb des Sensors in der Figur 1). Mit dem Widerstand $R_S$ des Sensors S ergibt sich für das Verhältnis der Ströme links und rechts des Schlitzes

$$I_1/I_2=(2R_2+R_S)/R_1=n.$$

Wird der Teilstrom $I_2$ mit dem Sensor S gemessen, ergibt sich der zu messende Gesamtstrom $I_{IN}$ daraus gemäß

$$I_{IN}=I_1+I_2=I_2(1+I_1/I_2)=I_2(1+n).$$

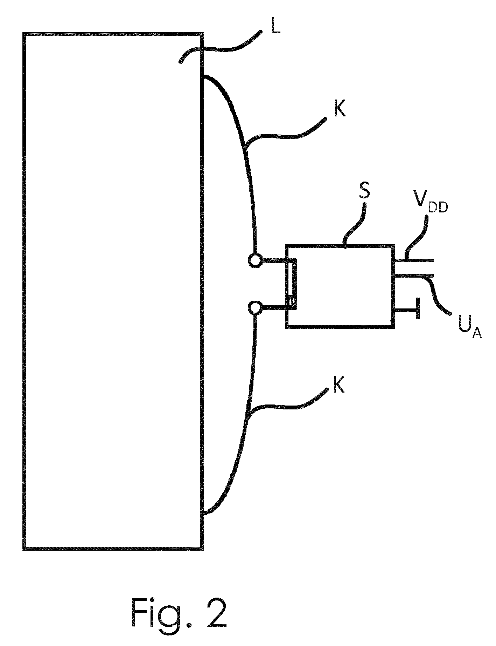

In der Figur 2 ist dargestellt, dass anstelle eines Schlitzes in einer Stromschiene oder Leiterbahn alternativ ein Parallelpfad auch mit Hilfe eines Kabels K realisiert werden kann. Diese Variante kann auch bei bestehenden Systemen ohne Notwendigkeit des Auftrennens bestehender Verschienungen nachgerüstet werden. Das Ersatzschaltbild aus Figur 3 gilt sinngemäß auch für diese Variante.

Eine Ausgestaltung dieser Ausführungsform kann für Leiterplatten (PCB - physical layer board) genutzt werden, wobei Haupt- und Teilstrom (Hauptstrompfad und Nebenstrompfad) in Leiterbahnen auf verschiedenen Lagen (Layern) aufgeteilt werden, wobei die Leiterbahnen des Hauptstrompfades und des Nebenstrompfades vorzugsweise übereinander überlappend angeordnet sind. Die Leiterbahnen sind an den Enden über Durchkontaktierungen, sog. "Vias", leitend miteinander verbunden. Die Leiterbahn für den Teilstrom, also der Nebenstrompfad, ist am Ort des Sensors S unterbrochen, der Strompfad für diesen Teilstrom wird über den Sensor S geschlossen. Für die Leiterbahnen für Haupt- und Teilstrom können unterschiedliche Kupferstärken, also eine unterschiedliche Dicke der leitfähigen Schicht, und/oder auch eine unterschiedliche Breite der Leiterbahnen verwendet werden. Bei einer Dickkupferleiterplatte kann z.B. der Hauptstrom auf einer Lage mit Dickkupfer geführt werden, und der Teilstrom auf einer Lage mit geringerer Kupferschichtdicke. Der Hauptstrom kann auch auf mehrere Leiterbahnen in unterschiedlichen Lagen aufgeteilt werden, um größere Gesamtströme zu erreichen.

Es ist in einer weiteren Ausgestaltung auch eine Kombination von Stromschienen, wie anhand der Figur 1 diskutiert, und Leiterplatten möglich, wobei dann über die Leiterplatte im wesentlichen der Nebenstrompfad realisiert wird; die Leiterplatte wird also anstelle des anhand der Figur 2 diskutierten Kabels K eingesetzt. Der Hauptstrom fließt in der Stromschiene, auf diese ist eine Leiterplatte so geschraubt, dass nur die Leiterbahn für den Teilstrom (Nebenstrompfad) leitend mit der Schiene verbunden ist. Die Enden des Nebenstrompfades können dazu mittels leitfähiger Schraubverbindungen mit der Stromschiene, also dem Hauptstrompfad, verbunden sein. Die Leiterbahn für den Teilstrom (Nebenstrompfad) ist am Ort des Sensors S unterbrochen, der Strompfad für den Teilstrom wird also über den Sensor S geschlossen.

Der vorgeschlagene Ansatz hat viele Vorteile gegenüber der bestehenden Lösung. Da anstelle des Gesamtstroms nur ein Teilstrom gemessen werden muss, können kleinere, leichtere Stromsensoren verwendet werden. Diese Stromsensoren sind zudem preiswerter, weisen eine geringere Verlustleistung auf und haben in der Regel eine höhere Bandbreite, d.h., es können hiermit schnellere transiente Vorgänge beobachtet werden. Zudem kann durch eine Ersparnis im Bauvolumen, der Masse und der Verlustleistung bei den Stromsensoren erzielt werden, was direkt zu einer Reduzierung der Masse, des Volumens und der Verlustleistung der Geräte führen, in denen die Stromsensoren eingesetzt werden. Dadurch ergeben sich Kostenvorteile und Wettbewerbsvorteile.

Mit dem vorgeschlagenen Ansatz wird zudem der Messbereich eines Sensors um den Faktor n erhöht, somit können Stromsensoren mit Primärstromanschluß für die Leiterplattenmontage (hier sind Anschlüsse am Sensor für den zu messenden Strom vorhanden, der durch den Sensor fließt) auch zur Messung von solchen Strömen verwendet werden, in denen ansonsten Durchsteckwandler (Stromwandler mit Ringkern ohne Anschlüsse für den Primärstrom - der Primärstrom muss dabei über eine Schiene/Kabel durch den Ringkern hindurch geführt werden) verwendet werden müssen. Stromsensoren mit Primärstromanschluß sind häufig einfacher konstruktiv zu handhaben; deren Einsatzgebiet wird durch die Anwendung der Erfindung deutlich erweitert.

In weiteren, nicht gesondert dargestellten Ausführungsbeispielen, welche im Übrigen den dargestellten und zuvor beschriebenen Ausführungsbeispielen entsprechen, sind die erfindungsgemäße Vorrichtung zur Messung einer Stromstärke sowie das erfindungsgemäße Verfahren zur Messung einer Stromstärke in besonderer Weise zur Messung der Stromstärke bei Wechselstrom ausgebildet.

Dazu ist anstelle einer reinen Skalierungseinrichtung eine Auswerteinrichtung vorhanden, die nicht allein dem Gesamtstrom mittels einer Skalierung des gemessenen Teilstroms auf das (n+1)-fache des gemessenen Teilstroms ermittelt. Vielmehr zieht die Auswerteinrichtung zusätzlich die Frequenz des gemessenen Teilstroms (und folglich die Frequenz des Gesamtstroms) heran. Beispielsweise ermittelt die Auswerteinrichtung die zeitliche Rate von Nulldurchgängen des mittels des Sensors gemessenen Teilstroms zur Bestimmung der Frequenz.

Zur Ermittlung der Stromstärke des Gesamtstroms wird zunächst mittels der für den Gleichstromfall geltenden Methode der Gesamtstrom über die zuvor beschriebene Skalierung des Teilstroms errechnet. Nachfolgend wird der derart ermittelte Wert mit einem vorab bestimmten frequenzabhängigen Korrekturfaktor korrigiert.

Beispielsweise ist der frequenzabhängige Korrekturfaktor vorab über eine Messung des Frequenzgangs der Vorrichtung bestimmt worden und liegt als Korrekturfaktor-Tabelle oder als Korrekturfaktor-Funktion vor.

Alternativ oder zusätzlich liegt der frequenzabhängige Korrekturfaktor als Modellfunktion, insbesondere eines zuvor modellierten Modells eines Ersatzschaltbildes, vor.

In einem weiteren, nicht eigens dargestellten Ausführungsbeispiel, welches im Übrigen dem Dargestellten entspricht, ist die jeweilige Frequenz oder eine Menge mehrerer diskreter Frequenzen vorab bekannt, sodass anstelle einer messtechnischen Erfassung der Frequenz lediglich eine parameterartige Berücksichtigung dieser diskreten im Betrieb möglichen Frequenzen erforderlich ist.

Zweckmäßig wird somit lediglich ein Korrekturfaktor für diese Frequenz(en) vorgehalten und berücksichtigt.

**Patentansprüche**

1.  Vorrichtung zur Messung einer Stromstärke ($I_{IN}$) in einem elektrischen Leiter (L),
    wobei eine Messeinrichtung (S) zur Messung der Stromstärke vorgesehen ist,
    **dadurch gekennzeichnet,**
    **dass** der elektrische Leiter (L) in eine Anzahl Teil-Leiter aufgeteilt ist, wobei die Teil-Leiter an ihren jeweiligen Enden elektrisch miteinander verbunden und in einem Bereich zwischen den jeweiligen Enden elektrisch voneinander isoliert sind,
    **dass** die Messeinrichtung (S) zur Messung einer Teil-Stromstärke ($I_2$) an oder in zumindest einem ersten der Teil-Leiter als Nebenstrompfad angeordnet ist und die verbleibenden Teil-Leiter einen Hauptstrompfad bilden, und
    **dass** eine Skaliereinrichtung zur Ermittlung der Stromstärke ($I_{IN}$) aus einem Messwert der Teil-Stromstärke ($I_2$) und anhand eines Teilungsverhältnis zwischen Nebenstrompfad und dem Hauptstrompfad oder dem gesamten Leiter (L) vorgesehen ist.

2.  Vorrichtung gemäß Patentanspruch 1,
    **dadurch gekennzeichnet,**
    **dass** der elektrische Leiter (L) streifenförmig ist, wobei durch eine schlitzförmige Unterbrechung in Längsrichtung eine Teilung in Hauptstrompfad und Nebenstrompfad gegeben ist.

3.  Vorrichtung gemäß Patentanspruch 1 oder 2,

**dadurch gekennzeichnet,**

**dass** der elektrische Leiter (L) eine Stromschiene einer elektrischen Energieversorgung ist.

4. Vorrichtung gemäß einem der vorhergehenden Ansprüche,

**dadurch gekennzeichnet,**

**dass** der elektrische Leiter (L) eine Leiterbahn einer Leiterplatte ist.

5. Vorrichtung gemäß einem der vorhergehenden Ansprüche,

**dadurch gekennzeichnet,**

**dass** der elektrische Leiter (L) mehradrig ist, wobei durch Herausführung oder Spleißung einer Anzahl Adern eine Teilung in Hauptstrompfad und Nebenstrompfad gegeben ist.

6. Vorrichtung gemäß einem der vorhergehenden Ansprüche,

**dadurch gekennzeichnet,**

**dass** der elektrische Leiter (L) aus einem Hauptleiter und einem zusätzlich vorgesehenen und parallel angeordnetem Messleiter besteht, wobei der Hauptleiter den Hauptstrompfad und der Messleiter den Nebenstrompfad bildet.

7. Vorrichtung gemäß einem der vorhergehenden Patentansprüche,

**dadurch gekennzeichnet,**

**dass** das durch die Skaliereinrichtung verwendete Teilungsverhältnis anhand des Verhältnisses der Impedanz des Nebenstrompfades zu der Impedanz des Hauptstrompfades bestimmt ist.

8. Vorrichtung gemäß einem der vorhergehenden Ansprüche,

**dadurch gekennzeichnet,**

**dass** das durch die Skaliereinrichtung verwendete Teilungsverhältnis anhand des Verhältnisses des gesamten Leiterquerschnitts des Leiters (L) zu dem Leiterquerschnitt des Nebenstrompfades bestimmt ist.

9. Vorrichtung zur Messung einer Stromstärke ($I_{IN}$) eines Stromes in einem elektrischen Leiter (L) mit einer Messeinrichtung (S) zur Messung der Stromstärke, bei welcher der elektrische Leiter (L) in eine Anzahl Teil-Leiter aufgeteilt ist, wobei die Messeinrichtung (S) zur Messung einer Teil-Stromstärke (12) in oder an zumindest einem ersten der Teil-Leiter als Nebenstrompfad angeordnet ist, wobei die Vorrichtung ausgebildet ist, zur Ermittlung der Stromstärke zumindest einen Messwert der Teil-Stromstärke heranzuziehen, insbesondere Vorrichtung nach einem der vorhergehenden Ansprüche, wobei die Vorrichtung ausgebildet ist, eine Frequenz des Stromes zur Ermittlung der Stromstärke heranzuziehen.

10. Vorrichtung nach dem vorhergehenden Anspruch, bei welchem die Teil-Leiter an ihren Enden miteinander verbunden sind und in einem Bereich zwischen den Enden elektrisch voneinander isoliert sind.

11. Vorrichtung nach einem der vorhergehenden Ansprüche, bei welchem diejenigen Teil-Leiter, welche nicht zu dem Nebenstrompfad gehören, einen Hauptstrompfad bilden, wobei vorzugsweise eine Skaliereinrichtung zur Ermittlung der Stromstärke ($I_{IN}$) zumindest aus einem Messwert der Teil-Stromstärke (12) und anhand eines Teilungsverhältnisses zwischen Nebenstrompfad und dem Hauptstrompfad oder dem gesamten Leiter (L) vorgesehen und insbesondere angeordnet ist, wobei die Messeinrichtung vorzugsweise Teil der Vorrichtung ist.

12. Verfahren zur Messung einer Stromstärke ($I_{IN}$) in einem elektrischen Leiter (L),
wobei eine Messeinrichtung (S) zur Messung der Stromstärke vorgesehen wird,
**dadurch gekennzeichnet,**
**dass** der elektrische Leiter (L) in eine Anzahl Teil-Leiter aufgeteilt wird, wobei die Teil-Leiter an ihren jeweiligen Enden elektrisch miteinander verbunden und in einem Bereich zwischen den jeweiligen Enden elektrisch voneinander isoliert werden,
**dass** die Messeinrichtung (S) zur Messung einer Teil-Stromstärke ($I_2$) in einem ersten der Teil-Leiter als Nebenstrompfad verwendet wird und die verbleibenden Teil-Leiter einen Hauptstrompfad bilden, und
**dass** eine Skaliereinrichtung die Ermittlung der Stromstärke ($I_{IN}$) zumindest aus einem Messwert der Teil-Stromstärke ($I_2$) und anhand eines Teilungsverhältnis zwischen Nebenstrompfad und dem Haupstrompfad oder dem gesamten Leiter (L) vornimmt.

13. Verfahren zur Messung einer Stromstärke (IIN) in einem elektrischen Leiter (L),
wobei eine Messeinrichtung (S) zur Messung der Stromstärke herangezogen wird,
**dadurch gekennzeichnet,**
**dass** ein elektrische Leiter (L) herangezogen wird, der in eine Anzahl Teil-Leiter aufgeteilt ist,
wobei die Messeinrichtung (S) zur Messung einer Teil-Stromstärke (12) in einem ersten der Teil-Leiter als Nebenstrompfad verwendet wird und die verbleibenden Teil-Leiter einen Hauptstrompfad bilden, und
wobei zur Ermittlung der Stromstärke ($I_{IN}$) vorzugsweise zumindest ein Messwert der Teil-Stromstärke (12) herangezogen wird, insbesondere Verfahren nach Anspruch 12, bei welchem zudem eine Frequenz des Stroms herangezogen wird.

**14.** Verfahren nach einem der beiden vorhergehenden Ansprüche, bei welchem eine Vorrichtung nach einem der Ansprüche 1 bis 11 herangezogen wird.

Fig. 1

Fig. 2

Fig. 3

Europäisches
Patentamt

European
Patent Office

Office européen
des brevets

**EUROPÄISCHER RECHERCHENBERICHT**

Nummer der Anmeldung

EP 16 16 2878

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | FR 3 006 056 A1 (CONTINENTAL AUTOMOTIVE FRANCE [FR]; CONTINENTAL AUTOMOTIVE GMBH [DE]) 28. November 2014 (2014-11-28) * Abbildungen 1, 2 * ----- | 1-4,6-8, 11,12,14 | INV. G01R1/20 G01R15/14 G01R19/00 |
| X | US 6 528 960 B1 (RODEN GAREY GEORGE [US] ET AL) 4. März 2003 (2003-03-04) * Abbildungen 2A, 2B, 3A, 4 * ----- | 1-8,11, 12,14 | |
| X | US 2013/015843 A1 (DOOGUE MICHAEL C [US] ET AL) 17. Januar 2013 (2013-01-17) * Abbildungen 1, 2 * ----- | 1-4,6-8, 11,12,14 | |
| X | US 4 492 919 A (MILKOVIC MIRAN [US]) 8. Januar 1985 (1985-01-08) * Abbildung 2a * ----- | 1-3,6-8, 11,12,14 | |
| X | US 5 841 272 A (SMITH EDWARD W [US] ET AL) 24. November 1998 (1998-11-24) * Abbildung 1 * ----- | 1-3,6-8, 11,12,14 | |
| X | DE 33 24 224 A1 (LANDIS & GYR AG [CH]) 13. Dezember 1984 (1984-12-13) * Abbildungen 1-3 * ----- | 1,5-8, 11,12,14 | RECHERCHIERTE SACHGEBIETE (IPC) G01R |
| X | Richard Dickinson ET AL: "Using Allegro Current Sensor ICs in Current Divider Configurations for Extended Measurement Range", Application Note AN295036, 1. Januar 2010 (2010-01-01), Seiten 1-11, XP055038926, Gefunden im Internet: URL:www.allegromicro.com/~/media/Files/Tec hnical-Documents/AN295036-Current-Sensor-I Cs-In-Current-Divider-Configurations.ashx [gefunden am 2012-09-24] * Abbildungen 1A, 1B * ----- | 1-4,6-8, 11,12,14 | |

Der vorliegende Recherchenbericht wurde für alle Patentansprüche erstellt

| Recherchenort | Abschlußdatum der Recherche | Prüfer |
|---|---|---|
| München | 22. September 2016 | Agerbaek, Thomas |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

    ................................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 16 16 2878

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-09-2016

| Im Recherchenbericht angeführtes Patentdokument | Datum der Veröffentlichung | Mitglied(er) der Patentfamilie | Datum der Veröffentlichung |
|---|---|---|---|
| FR 3006056 A1 | 28-11-2014 | KEINE | |
| US 6528960 B1 | 04-03-2003 | KEINE | |
| US 2013015843 A1 | 17-01-2013 | DE 112012002932 T5<br>JP 2014522980 A<br>US 2013015843 A1<br>WO 2013015956 A1 | 24-04-2014<br>08-09-2014<br>17-01-2013<br>31-01-2013 |
| US 4492919 A | 08-01-1985 | KEINE | |
| US 5841272 A | 24-11-1998 | CA 2240493 A1<br>EP 0868666 A1<br>JP 2000502448 A<br>US 5841272 A<br>WO 9722884 A1 | 26-06-1997<br>07-10-1998<br>29-02-2000<br>24-11-1998<br>26-06-1997 |
| DE 3324224 A1 | 13-12-1984 | CH 659895 A5<br>DE 3324224 A1 | 27-02-1987<br>13-12-1984 |

EPO FORM P0461

Für nähere Einzelheiten zu diesem Anhang : siehe Amtsblatt des Europäischen Patentamts, Nr.12/82